# EUROPÄISCHE PATENTSCHRIFT

(11) **EP 3 459 325 B1**
(45) Veröffentlichungstag und Bekanntmachung des Hinweises auf die Patenterteilung: **01.05.2024**
(21) Anmeldenummer: 17723679.1
(22) Anmeldetag: 12.05.2017
(51) Int. Cl.: H05K 1/18, H05K 3/00, G01D 11/24, H01L 23/31

(54) **VERFAHREN ZUM UMMANTELN EINER ELEKTRISCHEN EINHEIT UND ELEKTRISCHES BAUELEMENT**
METHOD FOR COVERING AN ELECTRIC UNIT, AND ELECTRIC COMPONENT
PROCÉDÉ POUR ENROBER UNE UNITÉ ÉLECTRIQUE ET COMPOSANT ÉLECTRIQUE

(30) Priorität: 20.05.2016 DE 102016208783
(43) Veröffentlichungstag der Anmeldung: 27.03.2019
(73) Patentinhaber: Continental Automotive Technologies GmbH, 30175 Hannover (DE)
(72) Erfinder: BIEBRICHER, Lothar, 61440 Oberursel (DE); HUBER, Dietmar, 63322 Rödermark (DE); RAUKOPF, Svenja, 35329 Gemünden Felda - Hainbach (DE); SCHILLINGER, Jakob, 85080 Gaimersheim (DE)
(74) Vertreter: Continental Corporation
(86) Internationale Anmeldenummer: PCT/EP2017/061500
(87) Internationale Veröffentlichungsnummer: WO 2017/198570

(56) Entgegenhaltungen:
- DE-A1-102007 057 904
- US-A1- 2013 106 408
- US-A1- 2013 154 626

## Beschreibung

Die Erfindung betrifft ein Verfahren zum Ummanteln einer elektrischen Einheit sowie ein elektrisches Bauelement, welches mittels eines solchen Verfahrens hergestellt wurde.

Bauelemente können beispielsweise in Form von Sensoren zur Messung von Beschleunigungen oder Drehraten oder auch von anderen Messgrößen wie beispielsweise magnetischen Drehfeldern oder Strömen und zur Weiterleitung der vorverarbeiteten Messsignale an eine übergeordnete Auswerteelektronik oder Steuerung verwendet werden. Derartige Bauelemente können beispielsweise eine bestückte Leiterplatte aufweisen, auf welcher diverse elektrische oder elektronische Komponenten vorhanden sind.

Bei bekannten Herstellungsverfahren wird eine bestückte Leiterplatte beispielsweise in ein Thermoplastgehäuse eingepresst, wobei nachfolgend ein Deckel gegossen und ausgehärtet wird oder auch aufgelasert wird. Unterschiedliche Designs und Fertigungskonzepte sind diesbezüglich für unterschiedliche Typen von Bauelementen, insbesondere für unterschiedliche Typen von Sensoren, bekannt.

Nachteilig an den bekannten Ausführungen ist insbesondere, dass sich die jeweilige Leiterplatte in einem Hohlraum befindet. Eindiffundierende Feuchtigkeit kann dabei zu Migration, Korrosion und Kurzschlüssen führen. Es hat sich gezeigt, dass kundenspezifisch vorgegebene Erfordernisse hinsichtlich des Bauraums nicht immer erfüllbar sind. Außerdem ist ein Abschirmblech nur mit einem großen Aufwand darstellbar. Höchste Dichtigkeitsklassen können typischerweise nicht erreicht werden. Es ist eine große Vielfalt an Designs und Fertigungsverfahren bzw. Anlagen erforderlich. Außerdem geht mit den bekannten Herstellungsverfahren ein großer Design-, Qualifikations- und Betreuungsaufwand einher. Aus der US 2013/154626 A1 und der US2013/106408 A1 sind Gehäuse bekannt, die jeweils einen ersten Kunststoffkörper aufweisen, der die Leiterplatte umhüllt, sowie einen zweiten Kunststoffkörper, der den ersten Kunststoff zumindest teilweise umhüllt, wobei der zweite Kunststoffkörper Unterbrechungen aufweisen kann. Bei diesen Gehäusen können Verspannungen aufgrund unterschiedlicher thermischer Ausdehnung zwischen Materialien auftreten, welche beispielsweise Messungen verfälschen können.

Es ist deshalb eine Aufgabe der Erfindung, ein Verfahren zum Ummanteln einer elektrischen Einheit bereitzustellen, welches insbesondere zumindest einen oder mehrere der genannten Nachteile vermeidet. Es ist des Weiteren eine Aufgabe der Erfindung, ein elektrisches Bauelement bereitzustellen, welches mit einem erfindungsgemäßen Verfahren hergestellt wurde.

Dies wird erfindungsgemäß durch ein Verfahren nach Anspruch 1 und ein elektrisches Bauelement nach Anspruch 13 erreicht. Vorteilhafte Ausgestaltungen können beispielsweise den jeweiligen Unteransprüchen entnommen werden. Der Inhalt der Ansprüche wird durch ausdrückliche Inbezugnahme zum Inhalt der Beschreibung gemacht.

Die Erfindung betrifft ein Verfahren zum Ummanteln einer elektrischen Einheit, wobei das Verfahren folgende Schritte aufweist:
- Verbinden der elektrischen Einheit mit einem Leadframe, dann
- Ummanteln der elektrischen Einheit mit einem ersten Kunststoffmaterial zur Ausbildung eines inneren Moldkörpers, so dass eine Mehrzahl von Kontakten der elektrischen Einheit aus dem inneren Moldkörper herausstehen,
- Ausstanzen des inneren Moldkörpers aus dem Leadframe,
- Ausbilden eines den inneren Moldkörper umgebenden äußeren Moldkörpers aus einem zweiten Kunststoffmaterial zumindest teilweise in Form einer Käfigstruktur, wobei der äußere Moldkörper nur teilweise an dem inneren Moldkörper an liegt und teilweise von dem inneren Moldkörper beabstandet ist. Der äußere Moldkörper weist einen Käfigbereich mit einer Anzahl von voneinander beabstandeten Streben oder Bügeln auf, welche jeweils vom inneren Moldkörper beabstandet sind.

Bei Ausführung des erfindungsgemäßen Verfahrens ist die elektrische Einheit vollständig umschlossen von einem typischerweise chemisch und mechanisch stabilen Kunststoffmaterial. Es ist keine Korrosion, Migration und Kurzschlussbildung zu erwarten. Außerdem kann Ultraschallschweißung von Zusatzkomponenten verwendet werden. Im Vergleich zu Verfahrensführungen, welche aus dem Stand der Technik bekannt sind, werden insgesamt weniger Prozesse benötigt, was den Verfahrensablauf beschleunigt und vereinfacht.

Durch die Ausbildung des äußeren Moldkörpers als Käfigstruktur wird vorteilhaft erreicht, dass eine Entkopplung zwischen äußerem Moldkörper und innerem Moldkörper erfolgt. Dies kann eine Verspannung des inneren Moldkörpers durch den äußeren Moldkörper vermeiden helfen. Es können dabei beispielsweise Protektoren gegen statische und dynamische Kräfte ausgebildet werden, welche die gesamte Einheit schützen. Im Unterschied zu einer Vollumformung mit Thermoplast bzw. allgemeiner dem zweiten Kunststoffmaterial ist hier der Vorteil der Entkopplung der beiden Umhüllungen durch einen Spalt gegeben. Thermomechanische Kräfte beispielsweise eines Thermoplasten auf einen Duroplasten und von dort auf ein Sensorelement werden weitestgehend unterbunden.

Die beabstandete Ausführung des äußeren Moldkörpers vom inneren Moldkörper erlaubt eine vorteilhafte Entkopplung zur Vermeidung des Entstehens von Spannungen, welche beispielsweise Messergebnisse eines Sensors verfälschen können.

Die Ausführung des äußeren Moldkörpers mit einem Käfigbereich erlaubt einen Schutz des inneren Moldkörpers ähnlich einem umgebenden Fahrradhelm. Sollte es beispielsweise zu Stößen auf den äußeren Moldkörper kommen, so werden diese nicht unmittelbar an den inneren Moldkörper weitergeleitet, was ebenfalls Verspannungen und damit verbundene Messfehler vermeiden hilft.

Gemäß einer bevorzugten Ausführung wird ein an den äußeren Moldkörper anliegender Teil des inneren Moldkörpers vor Aufbringen des äußeren Moldkörpers zumindest teilweise oberflächenbehandelt, insbesondere mittels Plasmabehandlung oder Laserbehandlung, um eine Dichtigkeit gegen Eindringen von Flüssigkeit zu erreichen. Durch eine solche Oberflächenbe-handlung wird ein durch die Ausführung mit einem nur teilweise ausgebildeten äußeren Moldkörper eventuell entstehendes Leck, welches zum Eindringen von Flüssigkeit führen könnte, ge-schlossen. Einem Ausfall der verbauten elektrischen oder elektronischen Komponenten durch eindiffundierende Feuchtigkeit wird auf diese Weise wirkungsvoll vorgebeugt.

Des Weiteren ist bei der erfindungsgemäßen Verfahrensführung die Integration eines Abschirmblechs besonders einfach möglich. Bei aus dem Stand der Technik bekannten Verfahrensführungen war hierzu ein erheblich größerer Aufwand erforderlich, um eine zuverlässige Anbringung eines solchen Abschirmblechs zu ermöglichen. Ein Abschirmblech kann insbesondere die Störfestigkeit von Elektronik und/oder Sensorik verbessern. Auf die Anbringung eines Abschirmblechs wird weiter unten näher eingegangen werden. Es sei erwähnt, dass ein Abschirmblech vorzugsweise von dem ersten Kunststoffmaterial mit ummantelt wird.

Unter dem Verbinden kann insbesondere ein Einpressen, Löten wie Hart- oder Weichlöten, Kleben, Schweißen wie Ultraschallschweißen, Laserschweißen oder Widerstandsschweißen, oder auch ein Sintern verstanden werden. Beim Schritt des Verbindens wird die elektrische Einheit typischerweise für den Rest der Prozessführung zuverlässig mit dem Leadframe verbunden, so dass diese im Leadframe gehalten wird. Der Leadframe kann beispielsweise Stecker- oder Crimp-Terminals aufweisen. Allgemeiner ausgedrückt können Metallstreifen für externe Kontaktierung bereits Teil des Leadframes sein.

Der Leadframe kann Indexlöcher aufweisen und somit zusätzlich als Transport- und Justagehilfe dienen.

Die elektrische Einheit kann beispielsweise ein beliebiges elektrisches Bauelement sein, welches zur Durchführung irgendwelcher elektrischer Funktionen geeignet ist.

Es kann des Weiteren auch ein Shunt-Widerstand angebracht werden, welcher insbesondere einen Abschnitt aufweisen kann, welcher aus Manganin ausgebildet ist. Hierbei handelt es sich um ein typischerweise verwendetes und bewährtes Widerstandsmaterial, welches eine zuverlässige Messung des durchfließenden Stroms mittels Abgreifen der darüber abfallenden Spannung erlaubt. Anstelle von Manganin kann beispielsweise auch ein anderes Widerstandsmaterial, insbesondere eine andere Kufer-Nickel-Mangan-Legierung, verwendet werden. Der Shuntwiderstand kann beispielsweise an zwei Punkten oder auch an mehr Punkten, beispielsweise an vier Punkten kontaktiert werden. Letzteres ermöglicht insbesondere eine Vierpunktmessung, welche beispielsweise in dem Fall vorteilhaft sein kann, dass ein nicht temperaturstabiles Material verwendet wird.

Es sei des Weiteren erwähnt, dass die elektrische Einheit bzw. eine Leiterplatte mittels des erfindungsgemäßen Verfahrens voll umschlossen werden kann, und zwar von einem chemisch und mechanisch stabilen Duroplastmaterial. Es ist keine Korrosion, Migration und Kurzschlussbildung zu erwarten. Dies erfüllt höchste Anforderungen an mechanische und chemische Beständigkeit. Ein Abschirmblech ist ohne wesentlichen Zusatzaufwand darstellbar.

Außerdem sei erwähnt, dass bei dem erfindungsgemäßen Verfahren ein Design für ein Neutralteil festgelegt werden kann und nur noch kundenspezifische Umspritzungsvarianten variiert zu werden brauchen. Dies bedeutet einen signifikant geringeren Invest, weniger Kernprozesse sowie hohe Stückzahlen für das Neutralteil. Baugruppen mit niedrigerer Stückzahl können kostengünstig mitgefertigt werden. Der Qualifikations-, Design- und Betreuungsaufwand wird verringert.

Als elektrische Einheit wird bevorzugt eine bestückte Leiterplatte verwendet. Hierbei kann es sich insbesondere um eine Schaltung zum Messen von Strömen handeln. Für derartige Leiterplatten hat sich das Verfahren als besonders vorteilhaft erwiesen. Es kann beispielsweise auch ein integrierter Schaltkreis (IC) verwendet werden. Insbesondere kann dieser für einen Sensor ausgebildet sein.

Die Leiterplatte kann beispielsweise starr, flexibel oder aus Keramik ausgebildet sein.

Als erstes Kunststoffmaterial kann insbesondere ein Duroplastwerkstoff verwendet werden. Dieser ist insbesondere chemisch und mechanisch stabil.

Als zweites Kunststoffmaterial kann insbesondere ein Thermoplastwerkstoff verwendet werden. Dieser ist einfach aufzubringen und hat sich als außenliegender Schutz bewährt.

Sofern während des Verfahrens Kontakte verbunden werden sollen, können diese insbesondere durch Schweißen, Hartlöten, Ultraschallschweißen, Laser-Schweißen, Kleben, Weichlöten, Sintern und/oder Widerstandsschweißen mit einem anderen Element, insbesondere einem Shunt-Widerstand, verbunden werden. Derartige Verfahren haben sich für typische Anwendungen bewährt.

Der Schritt des Verbindens der Kontakte mit dem Shunt-Widerstand wird gemäß einer Ausführung nach dem Schritt des Ummantelns mit dem ersten Kunststoffmaterial ausgeführt. Alternativ kann der Schritt des Verbindens der Kontakte mit dem Shunt-Widerstand auch vor dem Schritt des Ummantelns mit dem ersten Kunststoffmaterial ausgeführt werden.

Gemäß einer Weiterbildung ist auf der elektrischen Einheit zumindest ein Sensor aufgebracht, und das Verfahren weist vor dem Schritt des Ummantelns der elektrischen Einheit und des Abschirmblechs mit einem ersten Kunststoffmaterial folgenden Schritt auf:
- Abdecken des Sensors mit einem Schutzmaterial, insbesondere mit einem niedrigviskosen Material, bevorzugt mit einem Glob-Top-Material.

Eine solche Ausführung führt zu einem besonders vorteilhaften weiteren Schutz des Sensors, welcher damit vor chemischen und/oder mechanischen Beschädigungen geschützt werden kann.

Beim Schritt des Ummantelns mit dem ersten Kunststoffmaterial wird gemäß einer Ausführung vollständig ummantelt, gegebenenfalls mit Ausnahme von überstehenden Kontakten. Dies hat sich insbesondere deshalb bewährt, weil auf diese Weise ein besonders guter chemischer und mechanischer Schutz erreicht wird.

Der innere Moldkörper ist vorzugsweise nach dem Schritt des Ummantelns mit dem ersten Kunststoffmaterial mit einer Anzahl von eingelegten oder verankerten Unterstützungsstegen mit dem Leadframe verbunden. Dies erleichtert die Verfahrensführung und sorgt für eine definierte Position des inneren Moldkörpers.

Dabei können beispielsweise feste Unterstützungsstege, rückziehbare Unterstützungsstege sowie Ausführungen ohne Unterstützungsstege verwendet werden. Hierauf wird weiter unten näher eingegangen werden.

Unter einem eingelegten Unterstützungssteg kann insbesondere ein Unterstützungssteg verstanden werden, welcher sich beim Ausstanzen vollständig aus dem Moldkörper entfernen lässt. Unter einem verankerten Unterstützungssteg kann insbesondere ein Unterstützungssteg verstanden werden, welcher im Moldkörper derart verankert ist, dass ein Teil des Unterstützungsstegs in jedem Fall im Moldkörper verbleibt.

In dem inneren Moldkörper werden gemäß einer Ausführung eine Anzahl von konvexen und/oder konkaven Konturen ausgebildet. Diese können zur Justage weiterer Komponenten verwendet werden oder auch während des Moldens zur Fixierung des ersten Moldkörpers in einem zweiten Moldtool, also einem Moldtool für das Ausbilden des äußeren Moldkörpers.

Die Kontakte können vorteilhaft jeweils eine Anzahl von Sicken aufweisen. Dies erleichtert die Handhabung und führt zu einem besseren Halt in umgebenden Strukturen. Außerdem wird eine Kriechstrecke für eventuell eindringende Flüssigkeit verlängert.

Die elektrische Einheit kann eine Anzahl von Löchern zur Verankerung in dem ersten Kunststoffmaterial aufweisen. Dies verbessert den Halt der elektrischen Einheit in dem ersten Kunststoffmaterial, was Produktionsfehlern vorbeugt.

Beim Schritt des Ummantelns mit dem zweiten Kunststoffmaterial wird vorzugsweise ein Stecker ausgeformt, was ein einfaches Vorsehen einer Anschlusskomponente ermöglicht. Es können auch Einlegeteile eingebettet werden, so dass vorgefertigte Elemente verwendet und einfach mitverarbeitet werden können.

Beim Schritt des Ummantelns mit dem zweiten Kunststoffmaterial wird vorzugsweise ein Niet gemeldet, und zwar insbesondere zur Verbindung mit einer Zusatzkomponente. Dies erlaubt eine einfache Befestigung und Ausrichtung der Zusatzkomponente.

Gemäß einer Weiterbildung kann eine zusätzliche Oberflächen-aktivierung des inneren Moldkörpers erfolgen, insbesondere vor dem Schritt des Ummantelns mit dem zweiten Kunststoffmaterial. Dies führt zu einer verbesserten Haftung des äußeren Moldkörpers auf dem inneren Moldkörper.

Als Material für den äußeren Moldkörper, also als zweites Kunststoffmaterial, kann insbesondere PA (Polyamid), PBT (Polybutylenterephthalat), Hotmelt oder PU (Polyurethan) verwendet werden. Das Ummanteln mit dem zweiten Kunststoffmaterial kann insbesondere durch Injektionsmolden oder RIM-Molden erfolgen.

Es sei erwähnt, dass insbesondere auch ein Schritt des Verbindens zumindest eines ersten Kontakts und eines zweiten Kontakts mit einem Shunt-Widerstand ausgeführt werden kann. Dies kann insbesondere vor dem Ummanteln mit dem zweiten Kunststoffmaterial zur Ausbildung eines äußeren Moldkörpers erfolgen. Damit kann beispielsweise ein Batteriesensor vorteilhaft ausgebildet werden.

Gemäß einer Weiterbildung weist das Verfahren ferner vor dem Schritt des Ummantelns der elektrischen Einheit mit einem ersten Kunststoffmaterial folgenden Schritt auf:
- Anbringen eines der elektrischen Einheit zugeordneten Abschirmblechs.

Durch das Abschirmblech kann insbesondere eine bessere Abschirmung beispielsweise gegen elektrische oder elektromagnetische Störungen erreicht werden.

Gemäß einer Ausführung wird das Abschirmblech durch einen vor dem Schritt des Verbindens der elektrischen Einheit mit dem Leadframe durchgeführten Schritt des Ausstanzens des Abschirmblechs aus dem Leadframe angebracht. Dies erlaubt eine besonders einfache Bereitstellung des Abschirmblechs, welches beispielsweise als Teil des Leadframes hergestellt werden kann.

Das Abschirmblech kann als Formteil ausgebildet sein und durch Einpressen in die elektrische Einheit angebracht werden. Dies erlaubt eine separate Herstellung des Abschirmblechs und eine größere Gestaltungsfreiheit.

Das Abschirmblech kann insbesondere parallel zur elektrischen Einheit angebracht werden. Dies kann sich insbesondere auf jeweilige Erstreckungen des Abschirmblechs bzw. einer elektrischen Einheit, welche insbesondere als Platte ausgebildet sein kann, beziehen. Damit kann eine besonders vorteilhafte Abschirmwirkung erreicht werden.

Das Abschirmblech kann gemäß einer vorteilhaften Ausführung als Wanne ausgebildet sein, welche die elektrische Einheit aufnimmt. Damit kann eine mehrseitige Umschließung der elektrischen Einheit erreicht werden. Die Wanne kann dabei vorzugsweise mittels einer Wannenabdeckung abgedeckt werden. Damit kann besonders vorteilhaft eine allseitige Umschließung der elektrischen Einheit erreicht werden. Dies ermöglicht einen besonders vorteilhaften Schutz vor elektromagnetischer Strahlung und anderen vergleichbaren Einflüssen.

Die Erfindung betrifft des Weiteren ein elektrisches Bauelement, welches mittels eines Verfahrens gemäß der Erfindung hergestellt wurde. Hinsichtlich des Verfahrens kann auf alle hierin beschriebenen Ausführungen und Varianten zurückgegriffen werden. Der äußere Moldkörper stellt dabei typischerweise, gegebenenfalls mit vorstehenden Kontakten, das Bauelement dar. Weitere Merkmale und Vorteile wird der Fachmann den nachfolgend mit Bezug auf die beigefügte Zeichnung beschriebenen Ausführungsbeispielen entnehmen. Dabei zeigen:
- Fig. 1 bis 9:: mögliche Zustände in einem Verfahren,
- Fig. 10:: eine Abwandlung mit quer zu einer Leiterplatte stehenden Pins,
- Fig. 11:: eine Abwandlung mit nur teilweiser Umhüllung,
- Fig. 12:: eine Abwandlung mit zusätzlich geschütztem Sensor,
- Fig. 13:: die Abwandlung von Fig. 12 in einem späteren Verfahrensschritt,
- Fig. 14a, 14b:: erfindungsgemäße Ausführung mit nur teilweiser Umhüllung und ausgebildeten Protektoren,
- Fig. 15:: eine Abwandlung mit Abdeckwanne,
- Fig. 16:: die Abwandlung von Fig. 15 in einer Seitenansicht,
- Fig. 17:: die Abwandlung der Fig. 15 und 16 in einem späteren Verfahrensstadium,
- Fig. 18:: den Zustand von Fig. 17 in einer Seitenansicht,
- Fig. 19:: eine Abwandlung mit zusätzlichen Unterstützungsstegen,
- Fig. 20:: den Zustand von Fig. 19 in einer Seitenansicht,
- Fig. 21:: eine Abwandlung mit eingebettetem Messwiderstand,
- Fig. 22:: die Abwandlung von Fig. 21 in einer Draufsicht.

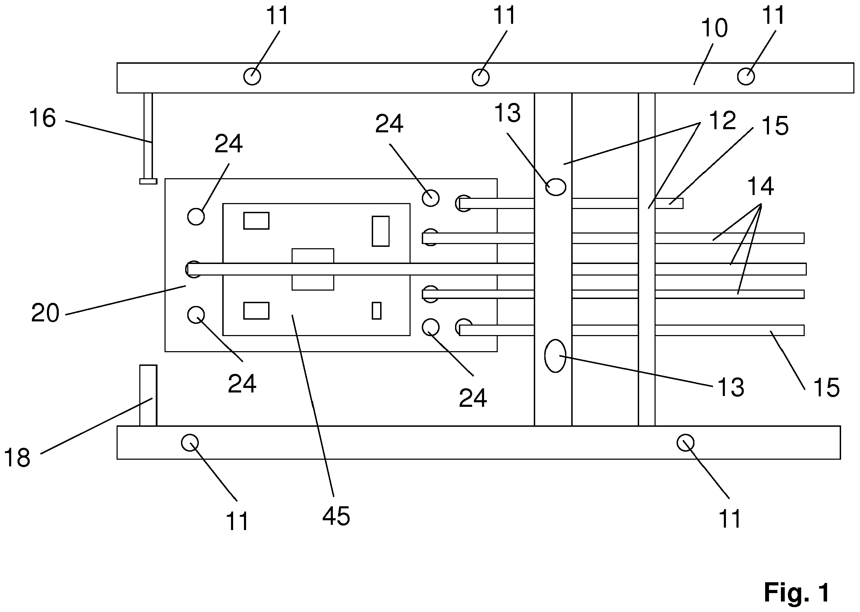

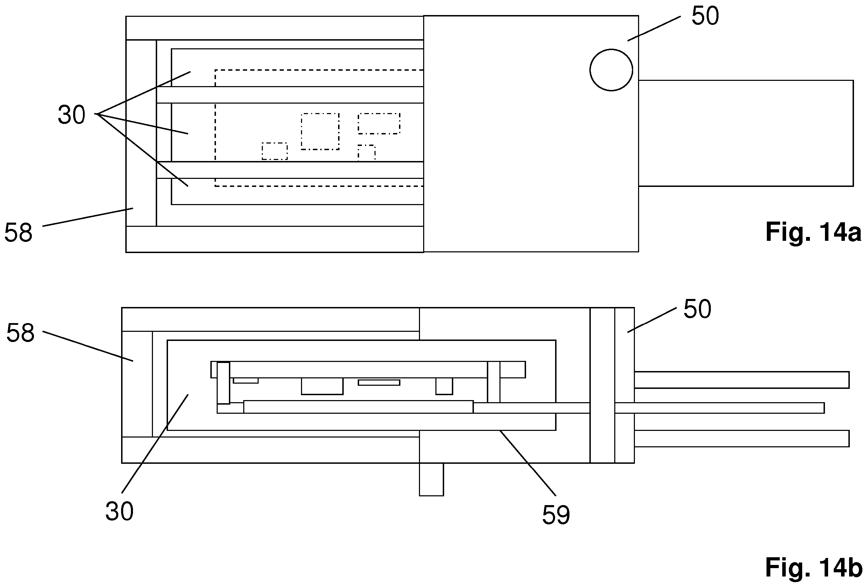

Fig. 1 zeigt eine Anordnung, wie sie typischerweise am Anfang eines erfindungsgemäßen Verfahrens auftritt. Es sei verstanden, dass zunächst ein allgemeineres Verfahren beschrieben wird und erst weiter unten mit Bezug auf Fig. 14 die käfigartige Struktur beschrieben werden wird.

Außenliegend ist ein Leadframe 10 angeordnet, in welchem Indexlöcher 11 ausgebildet sind. Der Leadframe 10 dient zur Stabilisierung und zum Transport, wobei er mittels der Indexlöcher 11 einfach gegriffen und bewegt werden kann. Die Indexlöcher 11 dienen insbesondere zum Transport des Leadframes 10 und zur Feinfixierung in einem Moldtool. Mittels der Indexlöcher erfolgt eine mechanische Justage des Leadframes 10 und damit des bereits assemblierten Bauelements bzw. eines Sensors in den verschiedenen Vorrichtungen und/oder Moldtools, welche im Rahmen des Verfahrens verwendet werden.

Der Leadframe 10 weist Dambars 12 auf, welche den Leadframe 10 stabilisieren und außerdem zum Anbringen weiterer Komponenten ausgebildet sind. In den Dambars 12 sind Fixierlöcher 13 ausgebildet, welche zum Fixieren des Leadframes 10 oder weiterer Komponenten dienen können. Die Fixierlöcher 13 dienen insbesondere zur Fixierung des freigestanzten Teils im Overmoldtool.

Der Leadframe 10 weist des Weiteren eine Anzahl von vorliegend drei Terminals in Form von Steckerterminals 14 auf, welche nach Abschluss des Herstellungsverfahrens als elektrische Kontakte dienen. Des Weiteren weist der Leadframe 10 zwei Shunt-Verbindungsterminals 15 auf, welche zum Anschließen eines Shuntwiderstands dienen. Außerdem weist der Leadframe 10 einen verankerten Unterstützungssteg 16 und einen eingelegten Unterstützungssteg 18 auf. Auf deren Funktion wird nachher noch näher eingegangen werden. Es sei verstanden, dass von den Unterstützungsstegen 16, 18 auch jeweils keiner oder eine Mehrzahl vorhanden sein können.

Mit dem Leadframe 10 ist eine elektrische Einheit in Form einer Leiterplatte 20 verbunden. Die Leiterplatte 20 ist an den Steckerterminals 14 und den Shunt-Verbindungsterminals 15 angebracht, und zwar vorliegend gelötet. Es können hier jedoch grundsätzlich auch die anderen weiter oben beschriebenen Verbindungstechniken verwendet werden, beispielsweise Ein-pressen. Dies sorgt für eine feste Verbindung zwischen der Leiterplatte 20 und dem Leadframe 10.

Zum Schutz der Leiterplatte 20 vor elektromagnetischen Einflüssen ist eine Abschirmplatte 45 angebracht. Diese ist parallel und oberhalb zur Leiterplatte 20 angeordnet.

Des Weiteren sind in der Leiterplatte 20 eine Anzahl von Löchern 24 ausgebildet, welche der Fixierung in einem weiter unten beschriebenen Moldkörper dienen.

In Fig. 1 ist die bestückte Leiterplatte 20 im Leadframeverbund dargestellt. Die Leiterplatte 20 dient hier insbesondere als Verdrahtungsträger für Sensoren und Zusatzbeschaltung. Es sind als Sensoren beispielsweise Beschleunigungs-Sensoren und Drehraten-Sensoren in jeglicher Kombination möglich. Ebenso können Magnetfeld-Sensoren und Strom-Sensoren verwendet bzw. hergestellt werden. Die Leiterplatte 20 kann durch die zusätzlichen Löcher 24 besser in dem weiter unten beschriebenen Moldkörper aus Duroplast verankert werden.

Im Leadframe 10 sind bevorzugt die Steckerterminals 14 bereits vorgestanzt. Es ist aber auch möglich, den Leadframe 10 in einem separaten Verbindungsprozess mit den Steckerterminals 14 zu verbinden.

Das Abschirmblech 45 kann direkt aus dem Leadframe 10 gestanzt werden oder als Formteil in die Leiterplatte 20 eingepresst werden.

Die Leiterplatte 20 wird in den Leadframe 10 vorzugsweise eingepresst. Es sind aber auch andere Verbindungstechniken, wie Löten und Kleben, denkbar.

Bei nichtgeraden Steckerterminals 14 können ausgeformte Steckerterminals 14 befestigt werden. Die Verbindung des Leadframes 10 mit den ausgeformten Steckerterminals 14 kann u.a. durch Schweißen, Löten, Kleben oder Splicen hergestellt werden.

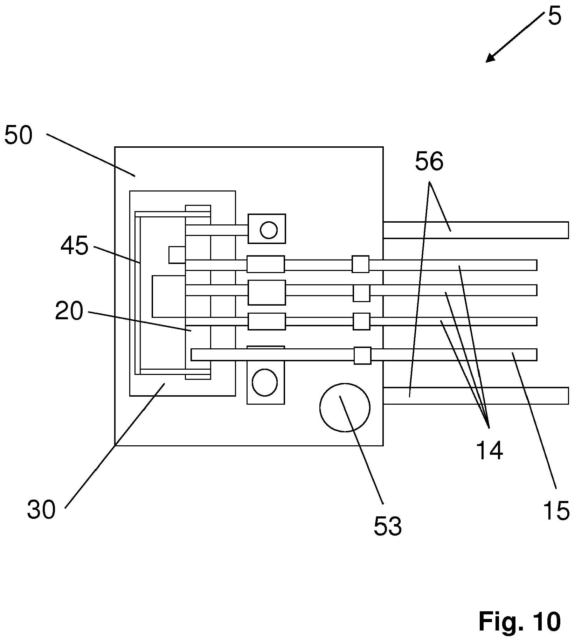

Neben einer bezüglich der Steckerterminals 14 parallelen Lage der Leiterplatte 20, wie dies in Fig. 1 dargestellt, ist auch eine senkrechte Lage darstellbar. Dies wird weiter unten in Fig. 10 gezeigt.

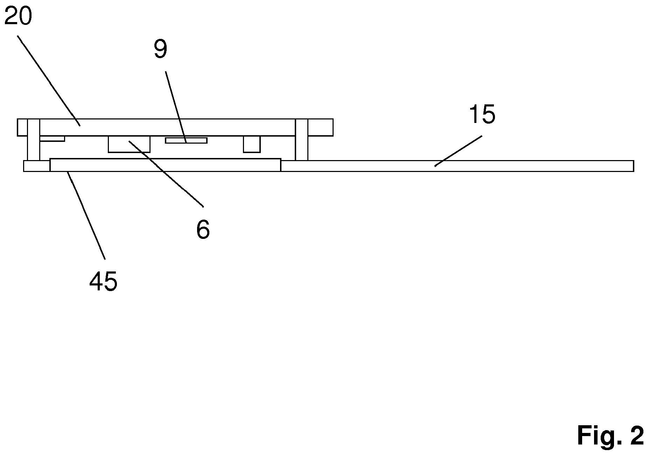

Fig. 2 zeigt die Anordnung von Fig. 1 in einer Seitenansicht nach dem Einpressen. Dabei ist des Weiteren zu erkennen, dass auf der Leiterplatte 20 ein Sensor 6 und außerdem eine Anzahl von elektrischen Komponenten 9 angeordnet sind. Diese sind vorliegend in SMD-Technik auf die Leiterplatte 20 aufgebracht.

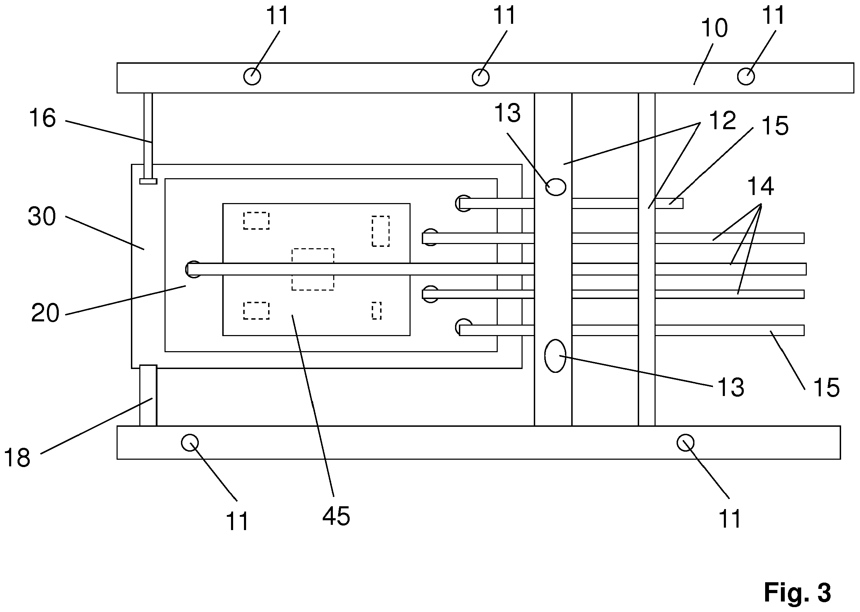

In Fig. 3 ist ein Zustand nach dem Aufbringen eines ersten Moldkörpers 30 dargestellt. Die Leiterplatte 20 ist von dem ersten Moldkörper 30 umgeben, welcher aus einem Duroplastmaterial besteht. Der erste Moldkörper 30 kann auch als innerer Moldkörper bezeichnet werden. Der erste Moldkörper 30 wurde durch Ummanteln der Leiterplatte 20 mittels eines Duroplastmaterials hergestellt.

Wie in Fig. 3 zu erkennen ist, ragen sowohl der verankerte Unterstützungssteg 16 wie auch der eingelegte Unterstützungssteg 18 in den ersten Moldkörper 30 hinein. Der verankerte Unterstützungssteg 16 ist dabei so ausgebildet, dass er einen Widerhaken im ersten Moldkörper 20 hat. Deshalb wird er auch als "verankert" bezeichnet. Der eingelegte Unterstützungssteg 18 weist hingegen keinen Widerhaken auf, so dass er einfach und vollständig aus dem ersten Moldkörper 30 herausgezogen werden kann. Der verankerte Unterstützungssteg 16 bleibt hingegen auf jeden Fall teilweise im ersten Moldkörper 30, wobei er mit seinem außerhalb des ersten Moldkörpers 30 liegenden Teil abgebrochen werden kann.

Der erste Moldkörper 30 sorgt insbesondere durch sein Duroplastmaterial für einen chemischen und mechanischen Schutz der Leiterplatte 20, wobei lediglich die Steckerterminals 14 und die Shunt-Verbindungsterminals 15 aus dem ersten Moldkörper 30 herausstehen.

Wie weiter unten gezeigt werden wird sind die beiden Shunt-Verbindungsterminals 15 U-förmig ausgebildet, so dass eine Verbindung von der Leiterplatte 20 zu einem Bereich neben der Leiterplatte 20 ausgebildet wird. Wie weiter unten ebenfalls gezeigt werden wird, dient dies zum Anschluss eines Shuntwiderstands.

Die bestückte Leiterplatte 20 hat im gezeigten Zustand keinen Kontakt zur Außenwelt. Sie ist vollständig von einem Duroplastwerkstoff umgeben. Dadurch ist das Risiko, dass Feuchtigkeit oder korrosive Medien auf die Leiterplatte 20 oder den Sensor einwirken, gering. Mechanische Spannungen auf die bestückten Komponenten der Leiterplatte sind gering oder vernachlässigbar, da der Ausdehnungskoeffizient des Duroplastmaterials in etwa gleich dem der Leiterplatte 20 und der darauf befindlichen Komponenten ist. Zudem ist die Haftung der Materialien zueinander sehr gut.

Die Unterstützungsstege 16, 18 können einbettbar oder verankerbar entworfen werden. Sie dienen dazu, den Moldkörper, der nur einseitig an der Dambarseite gehalten wird, zusätzlich gegen schwerkraftbedingtes Durchbiegen zu unterstützen. Diese Stege haben keine Verbindung zur Leiterplatte 20.

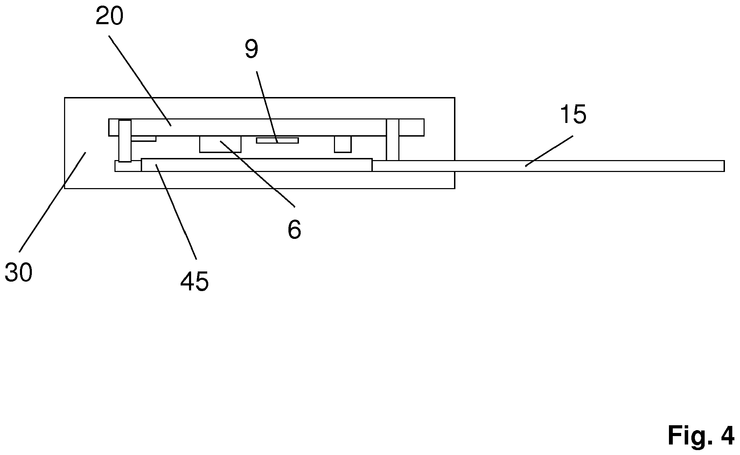

Fig. 4 zeigt die Anordnung von Fig. 3 in einer Seitenansicht.

Dabei ist des Weiteren zu erkennen, dass lediglich die Terminals 14, 15 über den ersten Moldkörper 30 hervorstehen. Grundsätzlich sei erwähnt, dass die Shunt-Verbindungsterminals 15 auch unter den ersten Moldkörper 30 hinausragen können.

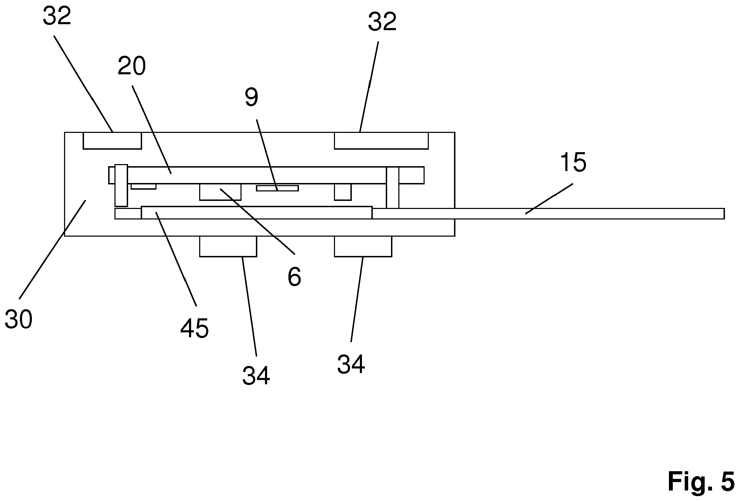

Fig. 5 zeigt die in Fig. 4 dargestellte Anordnung in einer Abwandlung. Dabei wurden in dem Moldkörper 30 vorliegend zwei konkave Fixierungen 32 und zwei konvexe Fixierungen 34 ausgebildet. Die Fixierungen 32, 34 dienen dazu, den Moldkörper 30 in einer übergeordneten Struktur zu verankern oder zu fixieren oder auch andere Komponenten an dem Moldkörper 30 anzubringen. Sie stellen insbesondere die Möglichkeit zur Verfügung, formschlüssige Verbindungen mit anderen Komponenten oder übergeordneten Strukturen auszubilden, beispielsweise zu einem Moldtool für eine weitere Ummantelung. Beispielsweise dienen sie zur Positionierung und Arretierung des Duroplast-Moldkörpers 30 im Thermoplast-Overmoldtool. Die Fixierungen 32, 34 können auch als Konturen bezeichnet werden. Es sei erwähnt, dass die Fixierungen 32, 34 bzw. entsprechende Elemente beispielsweise auch seitlich, also quer zur Papierebene von Fig. 5 ausgebildet sein können.

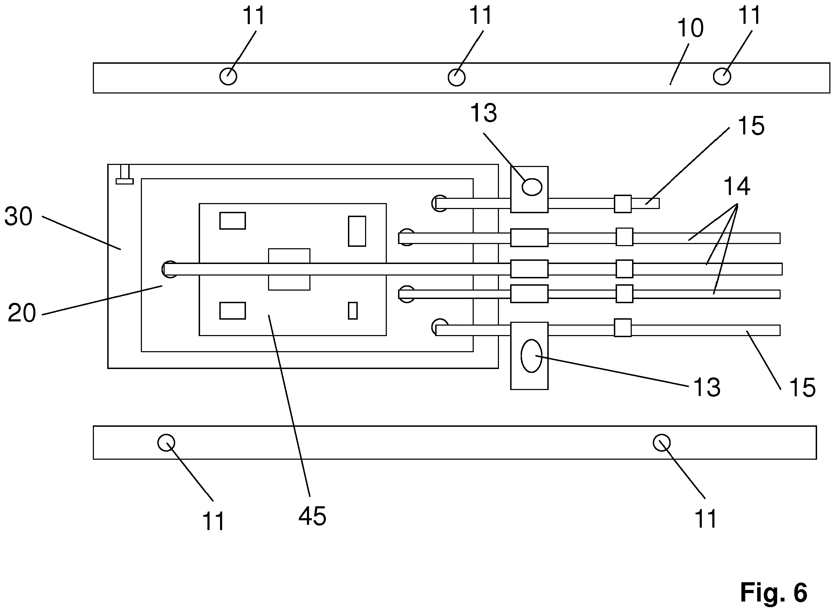

Fig. 6 zeigt die Anordnung von Fig. 3 nach einem Ausstanzen des ersten Moldkörpers 30 aus dem Leadframe 10. Dabei sind die Leiterplatte 20 mit dem sie umgebenden ersten Moldkörper 30 zu erkennen, wobei die damit verbundenen Terminals 14, 15 aus dem ersten Moldkörper 30 herausstehen, welche ursprünglich Teil des Leadframes 10 waren. Wie außerdem zu erkennen ist, verbleibt ein kleiner Teil des verankerten Unterstützungsstegs 16 in dem ersten Moldkörper 30. Der Rest des Leadframes 10 ist noch außen zu sehen.

In der Leiterplatte 20 sind wie weiter oben bereits beschrieben eine Anzahl von nun nicht mehr zu sehenden Ankerlöchern 24 ausgebildet, welche der besseren Fixierung der Leiterplatte 20 in dem ersten Moldkörper 30 dienen. Des Weiteren kann rechts von dem ersten Moldkörper 30 eine nicht näher dargestellte Entkopplungszone ausgebildet sein, in welcher eine gewisse Beweglichkeit zwischen den Terminals 14, 15 und der Leiterplatte 20 bzw. dem ersten Moldkörper 30 vorgesehen ist. Die Entkopplungszone hat sich insbesondere beim Ultraschall-Schweißen der Shunt-Verbindungsterminals 15 an einen Shuntwiderstand als vorteilhaft herausgestellt, da möglicherweise zur Delamination führende Schwingungseinkopplungen in den ersten Moldkörper 30 verhindert werden.

Im freigestanzten Teil sind nun die Terminals 14, 15 als Einzelpins ausgeführt. Bei Bedarf kann ein Programmierpin vorgesehen werden, der nach dem finalen Mold nicht mehr zugänglich ist.

Alle Terminals 14, 15 können mit Sicken versehen werden, um die Kriechstrecke für Feuchtigkeit zu verlängern und eine bessere Verankerung im Overmold zu erreichen.

Gemäß einer möglichen Ausführung kann eine in Fig. 6 nicht dargestellte Sicke vorgesehen sein, welche eine Kriechstrecke für Feuchtigkeit verlängert und eine bessere Verankerung in einem nachfolgend auszubildenden zweiten Moldkörper erlaubt.

Ausgehend von dem in Fig. 6 dargestellten Zustand kann ein in Fig. 6 nicht dargestellter Shuntwiderstand angebracht werden, welcher weiter unten als Shuntwiderstand 40 gezeigt ist. Der Shuntwiderstand 40 kann dabei vorliegend durch Ultraschallschweißen an Schweißstellen 42 an den Shunt-Verbindungsterminals 15 befestigt werden. Grundsätzlich können auch andere Verbindungstechniken wie weiter oben beschrieben verwendet werden. Durch die gezeigte Anordnung kann eine Spannung gemessen werden, welche in etwa entsprechend einer Breite des ersten Moldkörpers 30 an dem Shuntwiderstand 40 abfällt. Dies erlaubt einen Rückschluss auf den durchfließenden Strom.

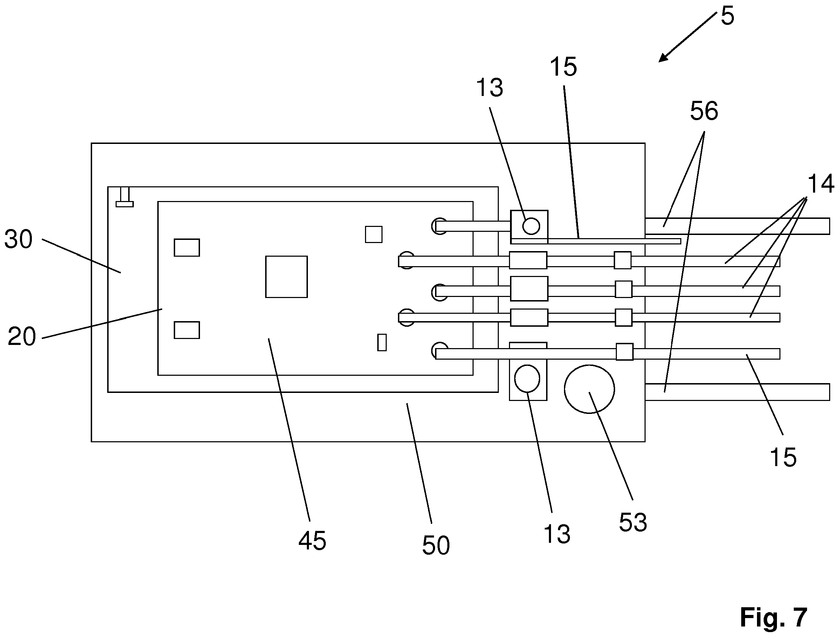

Fig. 7 zeigt einen Zustand der Anordnung von Fig. 6 nach dem Aufbringen eines zweiten Moldkörpers 50. Der zweite Moldkörper 50 kann auch als äußerer Moldkörper bezeichnet werden. Der zweite Moldkörper 50 besteht vorliegend aus einem Thermoplastmaterial und umgibt die Leiterplatte 20 und den ersten Moldkörper 30 sowie größtenteils die Shunt-Verbindungsterminals 15, die Steckerterminals 14 und, sofern vorhanden, den hier nicht gezeigten Shuntwiderstand 40. Ein Shunt-Verbindungsterminal 15, welches im Bild oben eingezeichnet ist, ist hinsichtlich seiner Kontaktierung nach außen etwas abgewandelt ausgeführt, insbesondere im Vergleich zum in Fig. 6 dargestellten Zustand.

Die Steckerterminals 14 stehen über den zweiten Moldkörper 50 hervor, so dass eine elektrische Kontaktierung der Leiterplatte 20 möglich ist. Des Weiteren stehen, sofern vorhanden, eine erste Kontaktierungsfläche und eine zweite Kontaktierungsfläche des Shuntwiderstands 40 über den zweiten Moldkörper 50 hervor, um einen Anschluss externer Komponenten zu ermöglichen. An diese Kontaktierungsflächen können beispielsweise andere elektrische Einheiten oder ein externer Stromkreis angeschlossen werden, wobei ein durch den Shuntwiderstand 40 fließender Strom von der Leiterplatte 20 gemessen werden kann. Entsprechende Signale, welche anzeigend für einen solchen Strom sind, können über die Steckerterminals 14 an weitere Einheiten gegeben werden.

Die finale Umhüllung der Duroplast-gemoldeten Leiterplatte 20 erfolgt besonders bevorzugt mit einem Thermoplastwerkstoff.

In diesem Arbeitsgang wird vorliegend auch ein Stecker 56 ausgeformt. Bei Bedarf können weitere Einlegeteile, wie z.B. Hülsen, Drehlager, Shunts, etc. in den Thermoplast-Körper eingebettet werden.

Es sei angemerkt, dass hier des Weiteren zu erkennen ist, dass sich in dem zweiten Moldkörper 50 ein Einlegeteil in Form eines Befestigungsteils 53 befindet. Dies erlaubt beispielsweise eine Befestigung an anderen Komponenten.

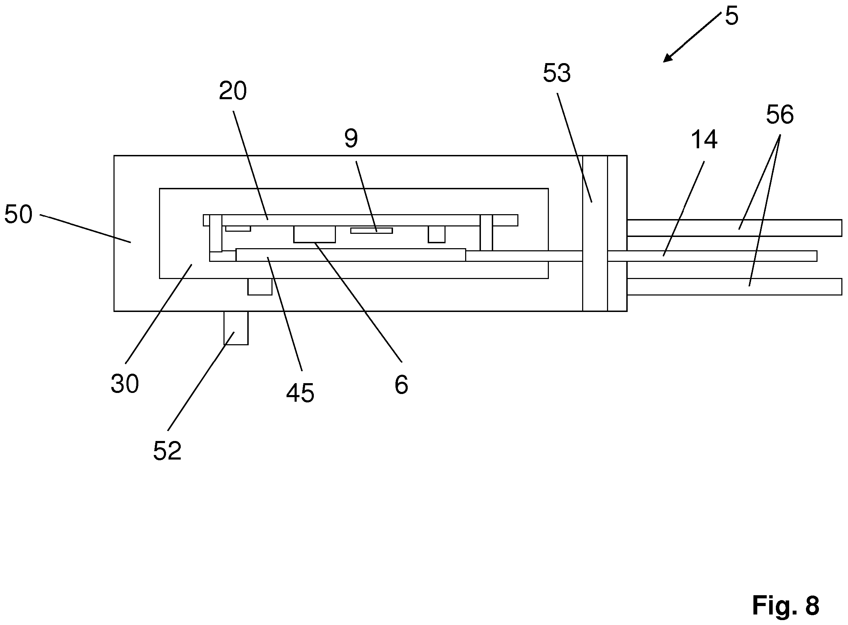

Fig. 8 zeigt die Anordnung von Fig. 7 in einer Seitenansicht. Bezüglich der einzelnen Merkmale sei auf die obige Beschreibung verwiesen.

An der Unterseite des zweiten Moldkörpers 50 ist des Weiteren ein Niet 52 zum Heißverstemmen ausgebildet. Außerdem ist rechts der Stecker 56 ausgebildet, welcher eine einfache Kontaktierung der Steckerterminals 14 und/oder der Shunt-Verbindungsterminals 15 erlaubt.

Es kann auch ein gemeldeter Fixierungsnippel oder Befestigungsdom vorgesehen werden.

Die in den Fig. 7 und 8 gezeigte fertige Anordnung nach Abschluss einer möglichen Ausführung des Verfahrens kann als elektrisches Bauelement 5 bezeichnet werden. Dieses kann in einer übergeordneten Komponente oder in einer Einheit wie beispielsweise einem Kraftfahrzeug verwendet werden, insbesondere um einen Strom zu messen.

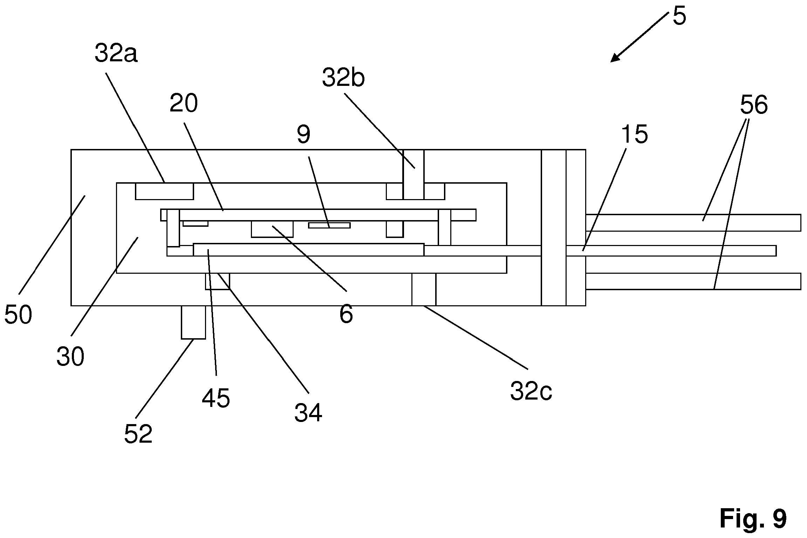

Für die Fixierung des Duroplastkörpers bzw. ersten Moldkörpers 30 im Overmold-Tool sind verschiedene Pinkonfigurationen möglich, welche schematisch in Figur 9 dargestellt sind. In Figur 9 ist dabei eine Abwandlung zur Ausführung nach Figur 8 gezeigt.

Zum einen kann ein zurückziehbarer Support-Pin bzw. Unterstützungssteg verwendet werden. Nach dem Schließen des Tools wird er entsprechend zurückgezogen. Ein mögliches Ergebnis ist in Fig. 9 mit Bezugszeichen 32a dargestellt.

Es kann auch ein fester Support-Pin bzw. Unterstützungssteg verwendet werden. Der Support-Pin bildet dabei die Kontur im Overmold ab. Ein mögliches Ergebnis ist in Fig. 9 mit Bezugszeichen 32b dargestellt.

Es kann auch eine Ausführung ohne Support-Pin bzw. Unterstützungssteg verwendet werden. Die erhabene Kontur des Duroplastkörpers dient dabei beispielsweise als Abstandshalter im Overmoldtool. Ein mögliches Ergebnis ist in Fig. 9 mit Bezugszeichen 32c dargestellt.

Ebenso kann der bereits erwähnte Fixierungsnippel 52 verwendet werden.

In Fig. 10 ist eine abgewandelte Ausführung dargestellt, in welcher die Leiterplatte 20 senkrecht zu den Steckerterminals 14 eingepresst ist. Dadurch sind beispielsweise andere Sensierungs-Richtungen bei Sensoren mit zur Messrichtung orthogonalen Sensierungs-Achsen realisierbar.

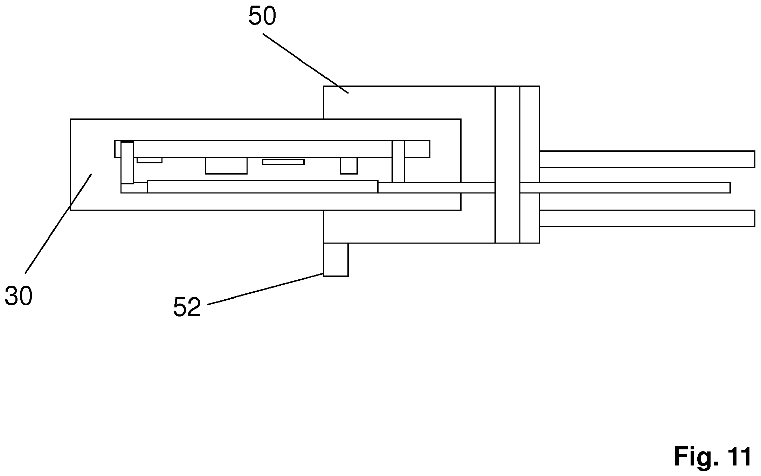

In Fig. 11 ist eine Abwandlung gezeigt, in welcher die Thermoplast-Umhüllung bzw. der zweite Moldkörper 50 durch partielle Ausformung so gestaltet ist, dass der thermomechanische Stress auf das Sensorelement minimiert wird. Der zweite Moldkörper umschließt dabei wie gezeigt den ersten Moldkörper 30 nicht vollständig, sondern nur partiell.

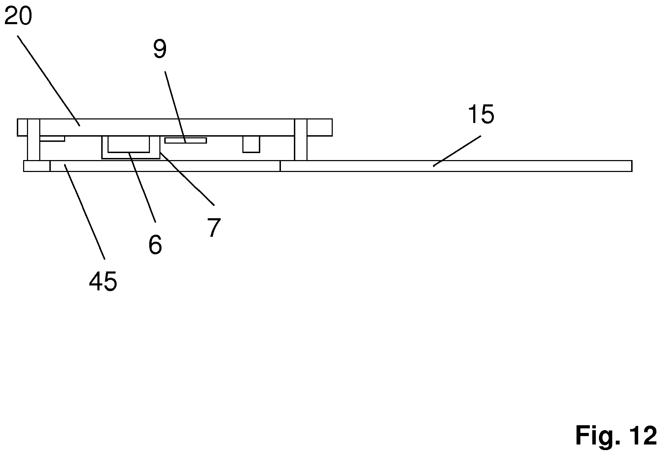

In Fig. 12 ist eine Abwandlung aus einem Zustand vor dem Aufbringen des ersten Moldkörpers 30 gezeigt, bei welchem über dem Sensor 6 eine Umhüllung 7 aus einem niedrigviskosen Material, insbesondere Globtop, aufgebracht wurde. Dies dient insbesondere dazu, den Sensor gegen thermomechanischen Stress in besonderer Weise zu schützen.

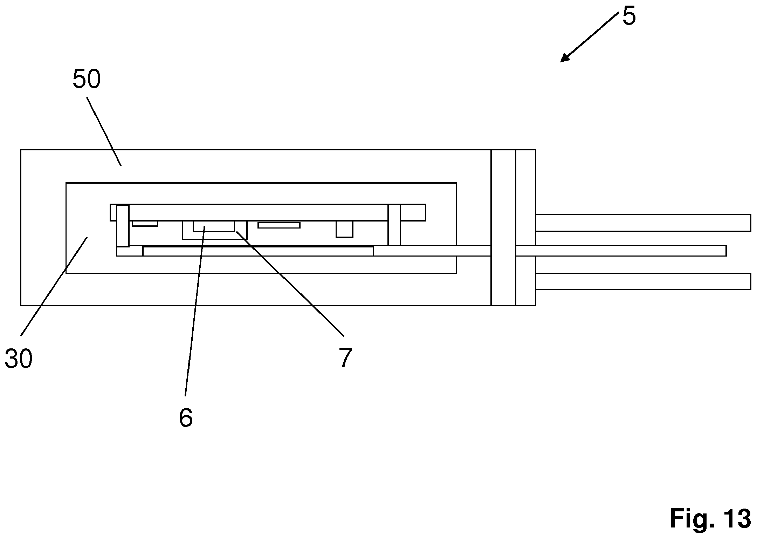

Fig. 13 zeigt die Ausführung von Fig. 12 nach dem Ummolden mit den beiden Moldkörpern 30, 50, also insbesondere als fertiges Bauteil 5.

Fig. 14a zeigt die erfindungsgemäße Ausführung eines fertigen Bauelements 5, bei welchem der zweite Moldkörper 50 den ersten Moldkörper 30 nicht vollständig umschließt, sondern vielmehr nur teilweise. Fig. 14a zeigt dabei eine Draufsicht. Fig. 14b zeigt den Zustand von Fig. 14a in einer Seitenansicht. Dies entspricht insbesondere einer erfindungsgemäßen Verfahrensführung.

In dem jeweiligen rechten Teil der Fig. 14a, 14b sind die beiden Moldkörper 30, 50 unmittelbar aneinander angrenzend ausgeführt. Dabei ist zwischen den beiden Moldkörpern 30, 50 eine Grenzfläche 59 ausgebildet, welche in besonderer Weise gegen Eindringen von Feuchtigkeit zu schützen ist. Hierauf wird weiter unten näher eingegangen werden.

Im dem jeweiligen linken Teil der Fig. 14a, 14b ist der zweite Moldkörper 50 in Form von Protektoren 58 ausgebildet. Diese umschließen den ersten Moldkörper 30 nur teilweise, so dass der erste Moldkörper 30 nach wie vor gesehen werden kann.

Die Protektoren 58 sind hinsichtlich ihrer Wirkung ähnlich einem Fahrradhelm ausgebildet, d.h. sie halten Stöße vom ersten Moldkörper 30 fern und sorgen für eine mechanische Entkopplung zwischen den beiden Moldkörpern 30, 50. Dadurch kann das Auftreten von mechanischen Verspannungen im ersten Moldkörper 30, welche beispielsweise bei Sensoren zu verfälschten Messergebnissen führen können, wirkungsvoll verhindert werden. Insbesondere kann beispielsweise das Auftreten thermischer Verspannungen bei Temperaturänderungen verhindert werden.

Allgemein sei darauf hingewiesen, dass Duroplast-Material typischerweise hart und spröde ist. Um dieses gegen mechanische Beschädigung zu schützen, kann es durch die Protektoren 58 gegen statische und dynamische Kräfte geschützt werden. Diese Protektoren 58 sind vorliegend bügelförmig ausgeführt, beispielsweise ähnlich einem Fahrradstutzhelm, und halten externe Kräfte vom Epoxi-Mold bzw. vom ersten Moldkörper 30 fern.

Im Unterschied zu einer Vollumhüllung mit Thermoplast, ist bei der erfindungsgemäßen Ausführung der Fig. 14a, 14b der Vorteil der Entkopplung der Duroplast- von der Thermoplast-Umhüllung durch einen Spalt gegeben. Thermomechanische Kräfte des Thermoplasts auf den Duroplast und von dort auf ein Sensorelement werden weitestgehend unterbunden.

Eine Spaltbildung zwischen Protektoren und Duroplast-Gehäuse wird beispielsweise durch eine spezielle Einstellung des Overmold-Prozesses oder werkzeuggebunden hergestellt.

Zusätzlich können die freiliegenden Flächen des Duroplastes zur Abstützung des Duroplast-Vorspritzlings im Thermoplast-Overmold-Tool dienen.

In einer Adhäsionszone bzw. der Grenzfläche 59, die durch besondere Oberflächenbearbeitung des Duroplast-Körpers erzielt wird, liegt eine verstärkte Haftung des Thermoplasts zum Duroplast vor. Hierdurch wird sichergestellt, dass keine korrosiven oder leitfähigen Materialien oder Flüssigkeiten in den Kontaktierungsbereich des Duroplastkörpers vordringen und dort die elektrische Kontaktierung schädigen oder kurzschließen. Die Oberflächenbehandlung oder Oberflächenbearbeitung eines Duroplastkörpers oder allgemeiner des ersten Moldkörpers 30 kann insbesondere durch Plasmabehandlung oder durch Laserbehandlung erfolgen. Dies hat sich zum Herstellen der gewünschten dauerhaften Dichtigkeit bewährt.

Vorteilhaft ist, wenn, wie hier dargestellt, die Leiterplatte 20 in zwei Moldschritten mechanisch und chemisch geschützt wird.

Bei besonderen Anwendungsfällen kann durch zusätzliche Oberflächenaktivierung des Duroplastkörpers eine verstärkte Haftung des Overmolds auf dem Duroplast-Mold erzielt werden.

Vorteilhaft ist, wenn die voll abgeglichenen und geprüften Sensoren als BGA oder QFN (mit und ohne interne Zusatzbeschaltung) verwendet werden können. Auf der Leiterplatte 20 ist dadurch eine kundenspezifische Beschaltung ohne erhöhten Aufwand möglich. Die Verbindungstechnik erfolgt vorzugsweise in Löttechnik, wie dies im Design des Sensors vorgesehen war. Insbesondere, jedoch nicht nur, bei BGA-Ausführungen kann der Duroplastmold auch als Underfiller verwendet werden.

Weiterhin vorteilhaft ist die Herstellung eines Neutralteils aus Duroplast, welches dann kundenspezifisch mit einem Thermoplast oder Duroplast oder Elastomer umspritzt werden kann.

In einer besonderen Ausprägung kann der Stecker durch ein Kabel ersetzt werden.

Vorteilhaft ist es, wenn die Abmessung der Leiterplatte standardisiert ist, da dann die Fertigungseinrichtungen auf dieses/diese Format(e) optimiert werden können. Dies entspricht der Strategie der IC-Hersteller durch die Festlegung der Gehäuseform.

Vorteilhaft ist in diesem Zusammenhang, wenn der Leadframe als Halter, Justage und elektrische Kontaktierung zur Leiterplatte wirkt. Dadurch benötigt die Leiterplatte 20 selbst keine direkte Verbindung nach außen. Sie ist durch das Duroplastmaterial, welches im Ausdehnungskoeffizienten sehr nahe am Leiterplattenmaterial liegt, vollständig eingehüllt. Die einzige Zutrittsstelle für Kontaminationen liegt im Bereich der Terminals. Diese Kanäle sind aber vorteilhaft abgedichtet, da das Duroplastmaterial eine Verbindung mit den Leadframe-Materialien eingeht.

In einer weiteren Ausprägung kann die Leiterplatte 20 durch einen oder mehrere integrierte Schaltkreise (IC) ersetzt werden, die mittels geeigneter Techniken wie beispielsweise Löten, Kleben oder Schweißen mit dem Leadframe verbunden werden. Zusatzbeschaltungen wie Kondensatoren können innerhalb des Duroplastes direkt auf den Leadframe-Terminals bestückt werden.

Als finale Umspritzungs-Werkstoffe, im Text allgemein als Thermoplast bezeichnet, kommen typischerweise PA, PBT, Hotmelt oder PU in Betracht. Das finale Umhüllen kann typischerweise durch Injektionsmolden oder RIM-Molden erfolgen.

Es sei allgemein darauf hingewiesen, dass in dieser Beschreibung häufig von einem Duroplasten, einem Duroplastmaterial oder einem Duroplastwerkstoff für den inneren Moldkörper und ebenso von einem Thermoplasten, einem Thermoplastmaterial oder einem Thermoplastwerkstoff für den äußeren Moldkörper gesprochen wird. Dies bezieht sich lediglich auf die derzeit als am geeignetsten angesehene Ausführung. Es sei verstanden, dass diese Begriffe grundsätzlich verallgemeinert werden können, insbesondere auf allgemeinere Kunststoffmaterialien oder allgemein Materialien bzw. Moldkörper. Die Offenbarung dieser Anmeldung umfasst vollständig eine entsprechende Abwandlung bzw. Erweiterung bzw. Verallgemeinerung.

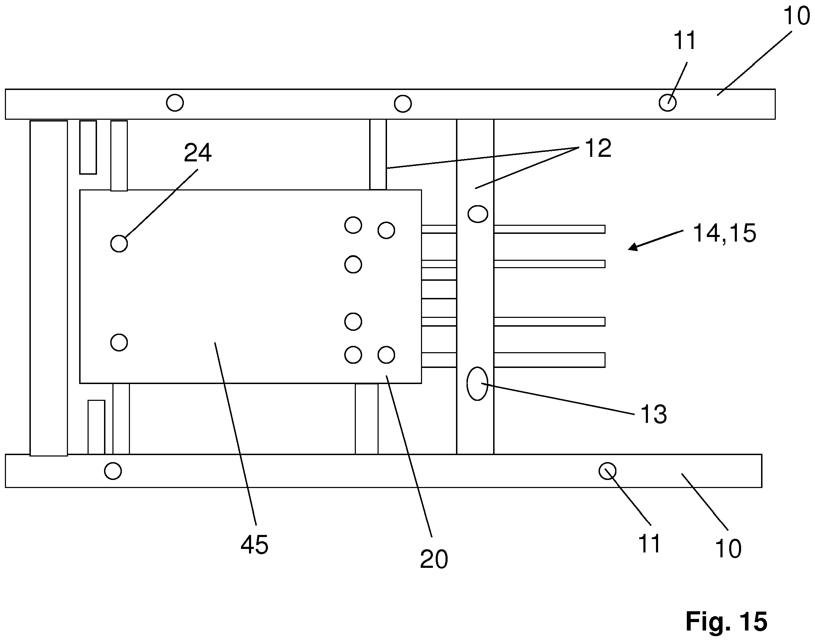

Die Figur 15 zeigt eine alternative Ausführung in einem Verfahrensstadium vor Aufbringen des ersten Moldkörpers 30, wobei anstelle eines bloßen Abschirmblechs eine Abschirmwanne 45 verwendet wird. Die Abschirmwanne 45 kann, wie in Fig. 15 dargestellt, insbesondere mit dem Leadframe 10 ausgebildet werden, wobei die Leiterplatte 20 in die ausgebildete Abschirmwanne 45 eingelegt oder auf sonstige Art eingebracht wird.

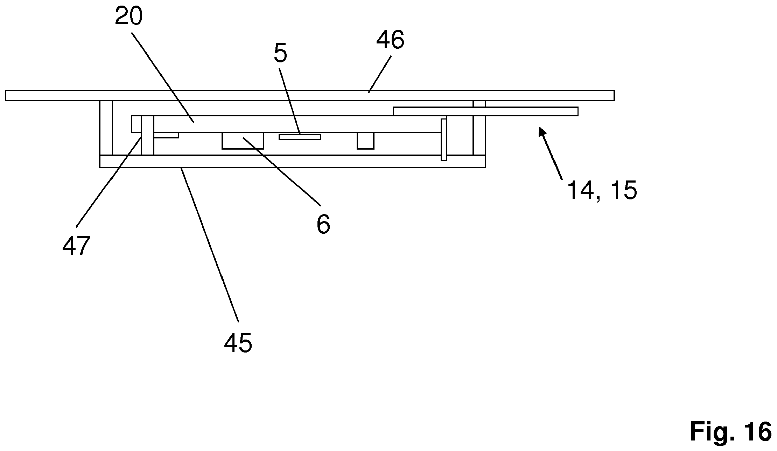

Fig. 16 zeigt eine Seitenansicht des in Fig. 15 dargestellten Zustands. Dabei ist die Abschirmwanne 45 in ihrer wannenartigen Ausbildung zu erkennen. Abgedeckt ist die Abschirmwanne 45 mit einem Deckel 46. Dies sorgt für eine allseitige Umschließung der Leiterplatte 20 und somit für einen besonders effektiven Schutz gegen elektromagnetische Störungen.

Des Weiteren ist zu erkennen, dass Leiterplatte 20 und Abschirmwanne 45 mittels eines Befestigungspins 47 miteinander verbunden sind. Damit wird eine stabile mechanische und elektrische Verbindung zwischen Abschirmwanne 45 und Leiterplatte 20 erreicht.

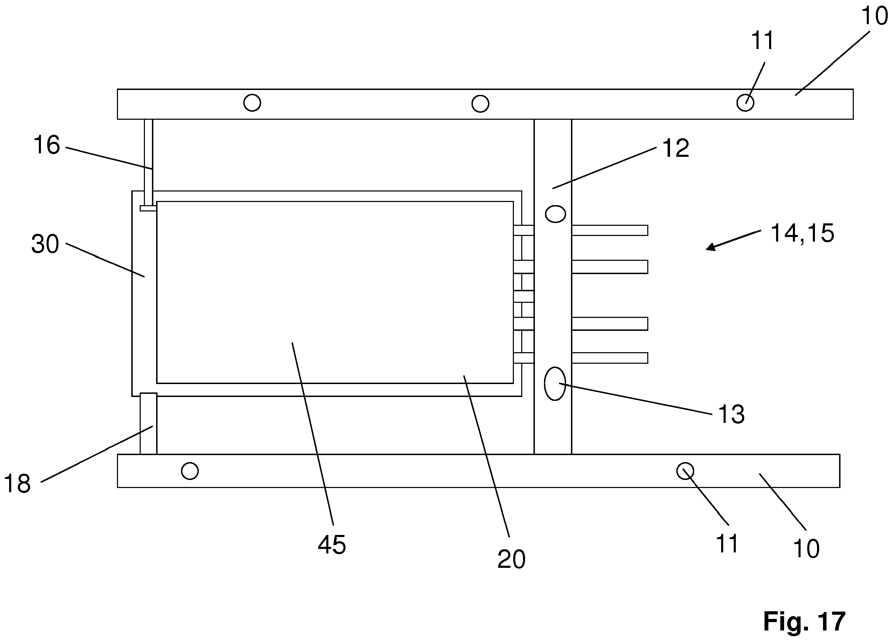

Fig. 17 zeigt die Ausführung von Fig. 15 und Fig. 16 nach dem Aufbringen des ersten Moldkörpers 30.

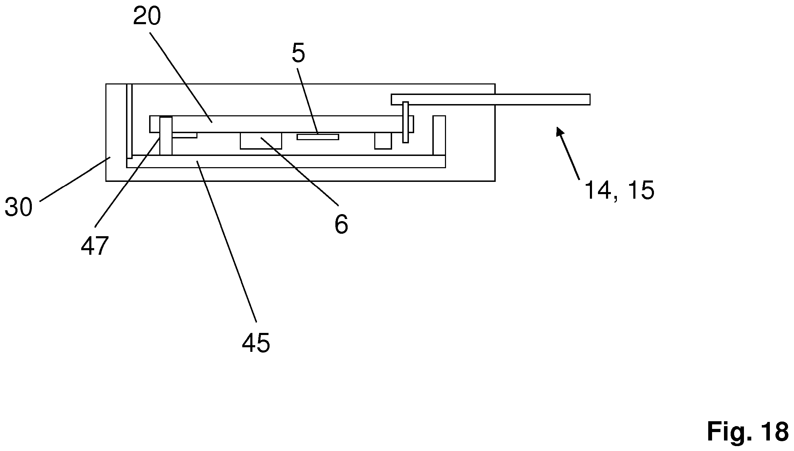

Fig. 18 zeigt den Zustand von Fig. 17 in einer Seitenansicht. Es sei angemerkt, dass dabei der Deckel 46 nicht eingezeichnet ist.

Allgemein sei angemerkt, dass in einer Ausprägung der Idee des gemeldeten Abschirmblechs das Abschirmblech als Wanne bzw. Abschirmwannne ausgebildet wird.

Diese Variante bietet die folgenden Vorteile.

Zum Fertigungsablauf sei erwähnt, dass der Leadframe 10 gestanzt und geformt werden kann, so dass fortlaufend Abschirmwannen 45 im Leadframeverbund gefertigt werden können, in welche die fertigbestückte und abgeglichene Leiterplatte 20 eingelegt und kontaktiert werden kann.

Dieses Zwischenprodukt kann nun freigestanzt oder auch im Leadframe-Verbund gemeldet werden, was bevorzugt mit Duroplast-Moldmaterial erfolgt. Abhängig von Design und Anforderung kann die Abschirmwanne 45 beispielsweise nur innenseitig mit Moldmaterial gefüllt werden oder sie kann auch komplett ummoldet sein.

Die Abschirmwanne 45 kann zusätzlich Befestigungselemente enthalten.

Die Wannenform ist insbesondere bei Hochfrequenz (HF) -Baugruppen vorteilhaft, wenn ein effektiver und wirkungsvoller Schutz gegen Störein- und Störabstrahlung erforderlich ist. Praktischerweise kann dieses Modul mit der Abschirmwanne 45 an der Außenseite an eine Metallfläche geschraubt werden, die die Abschirmung der zweiten Hälfte übernimmt.

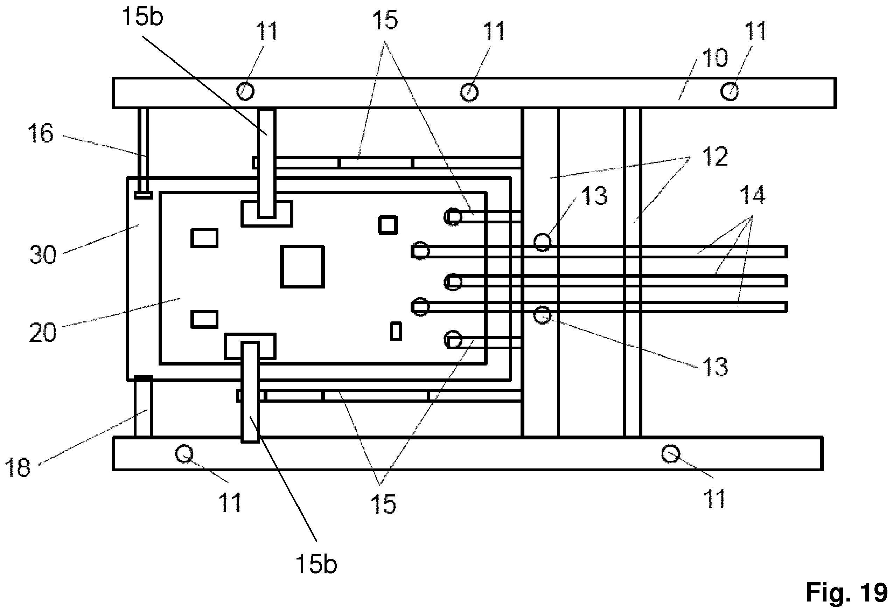

Fig. 19 zeigt eine Abwandlung zum Zustand von Fig. 3, wobei zusätzliche Unterstützungsstege 15b vorgesehen sind, welche den ersten Moldkörper 30 tragen. Damit kann die Stabilität weiter erhöht werden.

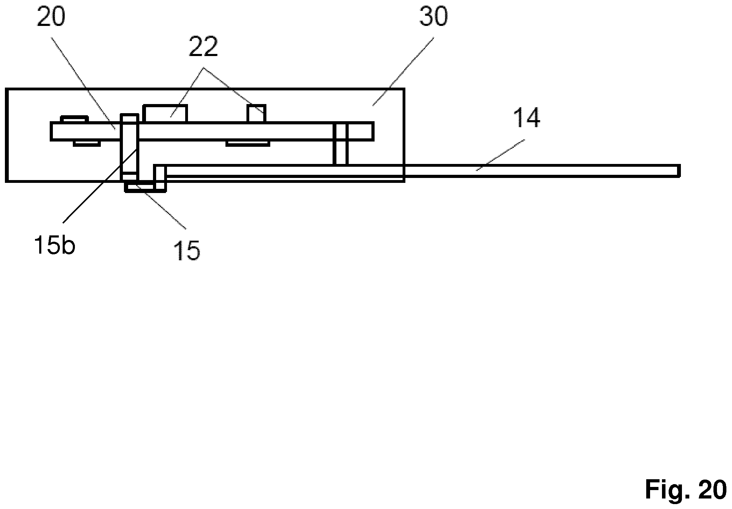

Fig. 20 zeigt den Zustand von Fig. 19 in einer Seitenansicht. Dabei ist zu erkennen, dass vertikale Teile der zusätzlichen Unterstützungsstege 15b, welche mit dem Bezugszeichen 15b bezeichnet sind, mit den Shunt-Verbindungsterminals 15 verbunden sind. Sofern diese mit einem Shuntwiderstand verbunden werden, was weiter unten näher dargestellt werden wird, können somit die vertikalen Teile 15b eine Verbindung des Shuntwiderstands zur Leiterplatte 20 herstellen, während der Shuntwiderstand mittels der Shunt-Verbindungsterminals 15 auch von außen kontaktiert werden kann.

Des Weiteren sind in der Ausführung von Fig. 20 Bauelemente 22 oberhalb der Leiterplatte 20 angebracht.

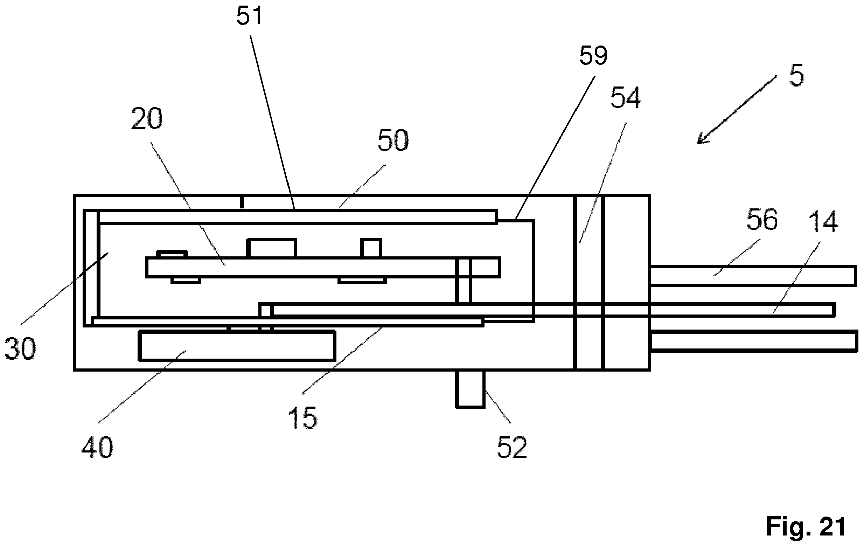

Fig. 21 zeigt eine Seitenansicht eines fertigen Bauelements 5 mit separaten Protektoren. Dabei ist zu erkennen, dass im rechten Teil der erste Moldkörper 30 und der zweite Moldkörper 50 unmittelbar an der Grenzfläche 59 aneinandergrenzen, während im linken Teil ein Spalt 51 zwischen erstem Moldkörper 30 und zweitem Moldkörper 50 ausgebildet ist. Durch den Spalt 51 wird das Ausbilden oder Übertragen von Verspannungen, welche Messergebnisse verfälschen können, wirkungsvoll vermieden.

Des Weiteren ist in der Ausführung nach Fig. 21 ein Shuntwiderstand 40 zu sehen, welcher unterhalb der Leiterplatte 20 in dem zweiten Moldkörper 50, nicht jedoch in dem ersten Moldkörper 30 eingebettet ist. Dieser Shuntwiderstand 40 kann insbesondere ein temperaturunabhängiger, beispielsweise temperatur- und/oder langzeitstabiler Referenzwiderstand sein, welcher für die Messung eines Stroms, insbesondere eines Batteriestroms, verwendet wird. Er wird durch die gezeigte Ausführung insbesondere vorteilhaft mechanisch stabilisiert und geschützt.

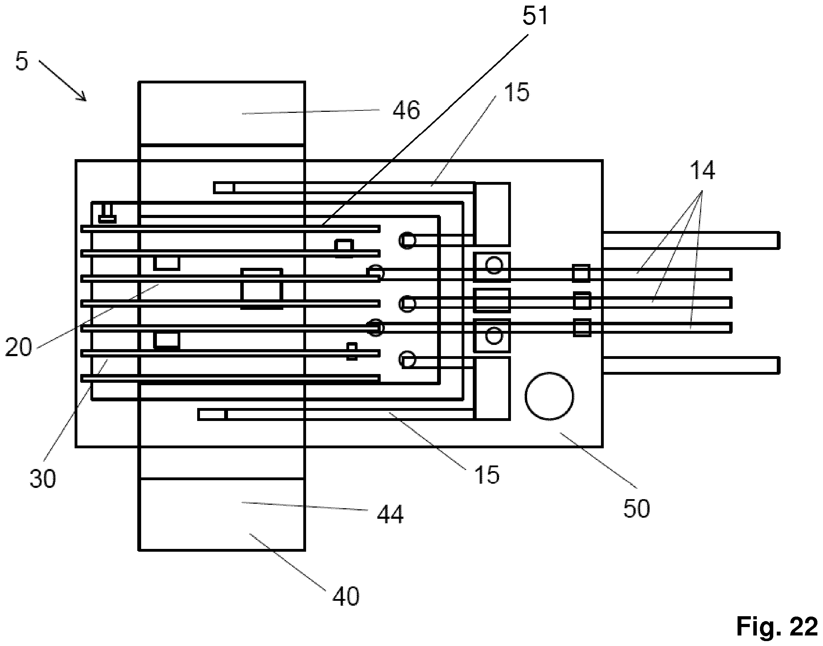

Fig. 22 zeigt eine Draufsicht auf den in Fig. 21 dargestellten Zustand. Dabei ist zu erkennen, dass seitlich zum ersten Moldkörper 30 ein erster Kontaktbereich 44 und ein zweiter Kontaktbereich 46 am Shunt 40 ausgebildet sind. Damit kann der Shunt an Leitungen oder Kabel angeschlossen werden, welche einen zu messenden Strom führen.

Im fertigen Bauelement ist der Shunt 40 insbesondere mit den Shunt-Verbindungsterminals 15 verbunden.

Allgemein kann der Shuntwiderstand 40 auch als Einlegeteil mit elektrischer Funktion bezeichnet werden, welches mit den Terminals 15 über den stirnseitigen Abgang oder mit den alternativen Terminals bzw. vertikalen Teilen 15b über den seitlichen Abgang an die Leiterplatte 20 angebunden sein kann. Dieses Teil kann auch entfallen und es bleibt nur eine mit Käfigstruktur realisierte Übermoldung bzw. ein zweiter Moldkörper 50.

Die Käfigstruktur des zweiten Moldkörpers 50 ist bei stressempfindlichen Bauteilen, wie z. B. bei Sensoren, vorteilhaft, da eine kraftschlüssige Verbindung lokal im Bereich des Sensors verhindert wird. Durch thermomechanische Verspannung oder durch die Schrumpfung, beispielsweise Nachkristallisation teilkristalliner Thermoplaste, hervorgerufene Schub-, Zug- oder Scherspannungen werden nicht auf den Duroplastmoldkörper 30 übertragen. Der darin eingebettete Sensor wird nicht bzw. kaum dem von außen wirkenden Stress ausgesetzt.

Es sei verstanden, dass diese Anmeldung allgemein insbesondere die folgenden Kombinationen offenbart:
- Mit Käfig und ohne elektrisches Einlegeteil (insbesondere Ummoldung von Sensoren)
- Mit Käfig und mit elektrischem Einlegeteil (insbesondere Stromsensor mit stressentkoppelter Ummoldung)

Die Bildung von Käfigstrukturen kann durch im Tool angebrachte Schieber oder auch durch gezielte Oberflächen-Aktivierung und Nicht-Aktivierung erfolgen.

Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden. Es können jedoch grundsätzlich auch weitere Schritte ausgeführt werden, auch solche welche nicht erwähnt sind.

## Patentansprüche

1. Verfahren zum Ummanteln einer elektrischen Einheit (20), wobei das Verfahren folgende Schritte aufweist:
- Verbinden der elektrischen Einheit (20) mit einem Leadframe (10), dann
- Ummanteln der elektrischen Einheit (20) mit einem ersten Kunststoffmaterial zur Ausbildung eines inneren Moldkörpers (30), so dass eine Mehrzahl von Kontakten (14, 15) der elektrischen Einheit (20) aus dem inneren Moldkörper (30) herausstehen,
- Ausstanzen des inneren Moldkörpers (30) aus dem Leadframe (10),
- Ausbilden eines den inneren Moldkörper (30) umgebenden äußeren Moldkörpers (50) aus einem zweiten Kunststoffmaterial zumindest teilweise in Form einer Käfigstruktur (50),
wobei der äußere Moldkörper (50) nur teilweise an dem inneren Moldkörper (30) anliegt und teilweise von dem inneren Moldkörper (30) beabstandet ist,
**dadurch gekennzeichnet, dass**, der äußere Moldkörper (50) einen Käfigbereich mit einer Anzahl von voneinander beabstandeten Streben oder Bügeln aufweist, welche jeweils vom inneren Moldkörper (30) beabstandet sind.

2. Verfahren nach einem der vorhergehenden Ansprüche,
wobei ein an den äußeren Moldkörper (50) anliegender Teil des inneren Moldkörpers (30) vor Aufbringen des äußeren Moldkörpers (50) zumindest teilweise oberflächenbehandelt wird, insbesondere mittels Plasmabehandlung oder Laserbehandlung, um eine Dichtigkeit gegen Eindringen von Flüssigkeit zu erreichen.

3. Verfahren nach einem der vorhergehenden Ansprüche,
wobei als elektrische Einheit (20) eine bestückte Leiterplatte oder ein integrierter Schaltkreis, insbesondere für einen Sensor, verwendet wird.

4. Verfahren nach einem der vorhergehenden Ansprüche,
wobei als erstes Kunststoffmaterial ein Durop-last-Werkstoff verwendet wird; und/oder
wobei als zweites Kunststoffmaterial ein Thermo-plast-Werkstoff verwendet wird.

5. Verfahren nach einem der vorhergehenden Ansprüche,
wobei auf der elektrischen Einheit zumindest ein Sensor (6) angebracht ist, und das Verfahren vor dem Schritt des Ummantelns der elektrischen Einheit (20) mit einem ersten Kunststoffmaterial folgenden Schritt aufweist:
- Abdecken des Sensors mit einen Schutzmaterial (7), insbesondere mit einem niedrigviskosen Material, bevorzugt mit einem Glob-Top-Material.

6. Verfahren nach einem der vorhergehenden Ansprüche,
wobei beim Schritt des Ummantelns mit dem ersten Kunststoffmaterial vollständig ummantelt wird, gegebenenfalls mit Ausnahme von überstehenden Kontakten (14, 15).

7. Verfahren nach einem der vorhergehenden Ansprüche,
wobei der innere Moldkörper (30) nach dem Schritt des Ummantelns mit dem ersten Kunststoffmaterial mit einer Anzahl von verankerten oder eingelegten Unterstützungsstegen (16, 18) mit dem Leadframe (10) verbunden ist.

8. Verfahren nach einem der vorhergehenden Ansprüche,
wobei in dem inneren Moldkörper (30) eine Anzahl von konkaven und/oder konvexen Konturen (32, 34) ausgebildet werden.

9. Verfahren nach einem der vorhergehenden Ansprüche,
wobei der erste Kontakt (15), der zweite Kontakt (15) und/oder eine Anzahl weiterer Kontakte (14) jeweils eine Anzahl von Sicken aufweist.

10. Verfahren nach einem der vorhergehenden Ansprüche,
wobei die elektrische Einheit (20) eine Anzahl von Löchern (24) zur Verankerung in dem ersten Kunststoffmaterial aufweist.

11. Verfahren nach einem der vorhergehenden Ansprüche,
wobei beim Schritt des Ummantelns mit dem zweiten Kunststoffmaterial ein Stecker (56) ausgeformt wird und/oder Einlegeteile (54) eingebettet werden.

12. Verfahren nach einem der vorhergehenden Ansprüche, welches ferner vor dem Schritt des Ummantelns der elektrischen Einheit (20) mit einem ersten Kunststoffmaterial folgenden Schritt aufweist:
- Anbringen eines der elektrischen Einheit (20) zugeordneten Abschirmblechs (45),
- wobei das Abschirmblech (45) beim Schritt des Ummantelns der elektrischen Einheit (20) mit einem ersten Kunststoffmaterial mit ummantelt wird.

13. Elektrisches Bauelement (5), welches mittels eines Verfahrens nach einem der vorhergehenden Ansprüche hergestellt wurde, wobei der äußere Moldkörper (50), ggf. mit vorstehenden Kontakten (14, 15), das Bauelement (5) darstellt.

## Claims

1. Method for encasing an electrical unit (20), wherein the method comprises the following steps:
- connecting the electrical unit (20) to a leadframe (10), then
- encasing the electrical unit (20) with a first plastic material for forming an inner moulded body (30), so that a plurality of contacts (14, 15) of the electrical unit (20) project from the inner moulded body (30),
- punching the inner moulded body (30) out of the leadframe (10),
- forming an outer moulded body (50), which surrounds the inner moulded body (30), from a second plastic material at least partially in the form of a cage structure (50), wherein the outer moulded body (50) rests only partially against the inner moulded body (30) and is partially spaced apart from the inner moulded body (30), **characterized in that** the outer moulded body (50) has a cage region with a number of spaced-apart struts or brackets which are each spaced apart from the inner moulded body (30).

2. Method according to any of the preceding claims,
wherein a part of the inner moulded body (30) that rests against the outer moulded body (50) is at least partially surface-treated, in particular by means of plasma treatment or laser treatment, in order to achieve leaktightness against the ingress of liquid, before the outer moulded body (50) is applied.

3. Method according to either of the preceding claims,
wherein the electrical unit (20) used is a populated printed circuit board or an integrated electrical circuit, in particular for a sensor.

4. Method according to any of the preceding claims,
wherein the first plastic material used is a thermoset material; and/or
wherein the second plastic material used is a thermoplastic material.

5. Method according to any of the preceding claims,
wherein at least one sensor (6) is attached to the electrical unit, and the method, before the step of encasing the electrical unit (20) with a first plastic material, comprises the following step:
- covering the sensor with a protective material (7), in particular with a lowviscosity material, preferably with a glob-top material.

6. Method according to any of the preceding claims,
wherein, in the step of encasing with the first plastic material, the electrical unit is completely encased, possibly with the exception of projecting contacts (14, 15).

7. Method according to any of the preceding claims,
wherein the inner moulded body (30) is connected to the leadframe (10) by way of a number of anchored or inserted support webs (16, 18) after the step of encasing with the first plastic material.

8. Method according to any of the preceding claims,
wherein a number of concave and/or convex contours (32, 34) are formed in the inner moulded body (30).

9. Method according to any of the preceding claims,
wherein the first contact (15), the second contact (15) and/or a number of further contacts (14) each has a number of beads.

10. Method according to any of the preceding claims,
wherein the electrical unit (20) has a number of holes (24) for the purpose of anchoring in the first plastic material.

11. Method according to any of the preceding claims,
wherein, in the step of encasing with the second plastic material, a plug (56) is formed and/or insert parts (54) are embedded.

12. Method according to any of the preceding claims,
which, before the step of encasing the electrical unit (20) with a first plastic material, further comprises the following step:
- attaching a shielding plate (45) associated with the electrical unit (20),
- wherein the shielding plate (45) is also encased in the step of encasing the electrical unit (20) with a first plastic material.

13. Electrical component (5), which has been produced by means of a method according to any of the preceding claims,
wherein the outer moulded body (50), possibly with protruding contacts (14, 15), constitutes the component (5).

## Revendications

1. Procédé permettant d'enrober une unité électrique (20), le procédé présentant les étapes suivantes consistant à :
- relier l'unité électrique (20) à une grille de connexion (10), ensuite
- enrober l'unité électrique (20) avec une première matière plastique pour réaliser un corps de moule intérieur (30) de sorte qu'une pluralité de contacts (14, 15) de l'unité électrique (20) font saillie du corps de moule intérieur (30).
- découper le corps de moule (30) dans la grille de connexion (10),
- réaliser un corps de moule extérieur (50) d'une deuxième matière plastique, entourant le corps de moule intérieur (30), au moins partiellement sous la forme d'une structure de cage (50), dans lequel le corps de moule extérieur (50) n'est que partiellement adjacent au corps de moule intérieur (30) est partiellement espacé du corps de moule intérieur (30),
**caractérisé en ce que** le corps de moule extérieur (50) présente une zone de cage avec un certain nombre d'entretoises ou d'attaches espacées les unes des autres qui sont espacées respectivement du corps de moule intérieur (30).

2. Procédé selon l'une quelconque des revendications précédentes,
dans lequel une partie du corps de moule intérieur (30), adjacente au corps de moule extérieur (50), est au moins partiellement traitée en surface avant l'application du corps de moule extérieur (50), en particulier au moyen d'un traitement au plasma ou d'un traitement au laser, pour obtenir une étanchéité contre la pénétration de liquide.

3. Procédé selon l'une quelconque des revendications précédentes,
dans lequel une carte de circuits imprimés équipée ou un circuit intégré, en particulier pour un capteur, est utilisé(e) comme unité électrique (20).

4. Procédé selon l'une quelconque des revendications précédentes,
dans lequel un plastique thermodurcissable est utilisé comme première matière plastique ; et/ou
dans lequel un thermoplaste est utilisé comme deuxième matière plastique.

5. Procédé selon l'une quelconque des revendications précédentes,
dans lequel au moins un capteur (6) est appliqué à l'unité électrique, et le procédé présente avant l'étape d'enrobage de l'unité électrique (20) avec une première matière plastique l'étape suivante consistant à :
- couvrir le capteur avec un matériau de protection (7), en particulier avec un matériau à faible viscosité, de préférence avec un matériau Glob-Top.

6. Procédé selon l'une quelconque des revendications précédentes,
dans lequel à l'étape d'enrobage avec la première matière première, un enrobage complet est effectué, le cas échéant à l'exception de contacts faisant saillie (14, 15).

7. Procédé selon l'une quelconque des revendications précédentes,
dans lequel, après l'étape d'enrobage avec la première matière plastique, le corps de moule intérieur (30) est relié à la grille de connexion (10) par un certain nombre d'entretoises de support (16, 18) ancrées ou insérées.

8. Procédé selon l'une quelconque des revendications précédentes,
dans lequel un certain nombre de contours concaves et/ou convexes (32, 34) sont réalisés dans le corps de moule intérieur (30).

9. Procédé selon l'une quelconque des revendications précédentes,
dans lequel le premier contact (15), le deuxième contact (15) et/ou un certain nombre d'autres contacts (14) présentent respectivement un certain nombre de moulures.

10. Procédé selon l'une quelconque des revendications précédentes,
dans lequel l'unité électrique (20) présente un certain nombre de trous (24) pour l'ancrage dans la première matière plastique.

11. Procédé selon l'une quelconque des revendications précédentes,
dans lequel, à l'étape d'enrobage avec la deuxième matière plastique, un connecteur (56) est façonné et/ou des inserts (54) sont incorporés.

12. Procédé selon l'une quelconque des revendications précédentes,
qui présente en outre avant l'étape d'enrobage de l'unité électrique (20) avec une première matière plastique l'étape suivante consistant à :
- appliquer une tôle de blindage (45) associée à l'unité électrique (20),
- dans lequel la tôle de blindage (45) est enrobée avec une première matière plastique à l'étape d'enrobage de l'unité électrique (20).

13. Composant électrique (5) qui a été fabriqué au moyen d'un procédé selon l'une quelconque des revendications précédentes,
dans lequel le corps de moule extérieur (50), le cas échéant avec des contacts faisant saillie (14, 15), est le composant (5).
